# EUROPÄISCHE PATENTSCHRIFT

(11) **EP 1 296 376 B1**
(45) Veröffentlichungstag und Bekanntmachung des Hinweises auf die Patenterteilung: **02.01.2013**
(21) Anmeldenummer: 02015875.4
(22) Anmeldetag: 16.07.2002
(51) Int. Cl.: H01L 25/13, H01L 33/00, C09K 11/08, C09K 11/77, C09K 11/59, C09K 11/64

(54) **Beleuchtungseinheit mit mindestens einer LED als Lichtquelle**
Illumination device with at least one LED as the light source
Unité d'éclairage comportant au moins une diode électroluminescente comme source de lumière

(30) Priorität: 25.09.2001 DE 10147040
(43) Veröffentlichungstag der Anmeldung: 26.03.2003
(60) Teilanmeldung: 10185943.7
(73) Patentinhaber: OSRAM AG, 81543 München (DE)
(72) Erfinder: Ellens, Andries, Dr., 2561 SL Den Haag (NL); Fries, Torsten, Dr., 86391 Stadtbergen (DE); Fiedler, Tim, 48429 Rheine (DE); Huber, Günter, 86529 Schrobenhausen (DE)

(56) Entgegenhaltungen:
- EP-A- 1 104 799
- US-A- 5 292 489
- US-A- 6 069 440
- UHEDA K ET AL: "Synthesis and luminescent property of Eu3+-doped LaSi3N5 phosphor" JOURNAL OF LUMINESCENCE, AMSTERDAM, NL, Bd. 87-89, 2000, Seiten 967-969, XP002405610 ISSN: 0022-2313
- VAN KREVEL J W H ET AL: "On the Ce<3+> luminescence in the melilite-type oxide nitride compound Y2Si3-xAlxO3+xN4-x" MATERIALS RESEARCH BULLETIN, ELSEVIER, KIDLINGTON, GB, Bd. 35, Nr. 5, 15. März 2000 (2000-03-15), Seiten 747-754, XP004215129 ISSN: 0025-5408
- VAN KREVEL J W H ET AL: "Long wavelength Ce<3+> emission in Y-Si-O-N materials" JOURNAL OF ALLOYS AND COMPOUNDS, ELSEVIER SEQUOIA, LAUSANNE, CH, Bd. 268, Nr. 1-2, 27. März 1998 (1998-03-27), Seiten 272-277, XP004130688 ISSN: 0925-8388
- KREVEL VAN: "LUMINESCENCE PROPERTIES OF RARE EARTH DOPED ALPHA-SIALON MATERIALS" ON NEW RARE-EARTH DOPED M-SI-AL-O-N MATERIALS, XX, XX, 2000, Seiten 145-157, XP008060386

## Beschreibung

### Technisches Gebiet

Die Erfindung geht aus von einer Beleuchtungseinheit mit mindestens einer LED als Lichtquelle gemäß dem Oberbegriff des Anspruchs 1. Es handelt sich dabei insbesondere um eine im Sichtbaren oder Weiß emittierende LED auf Basis einer primär UV oder blau emittierenden LED.

### Stand der Technik

Eine Beleuchtungseinheit, die beispielsweise weißes Licht abgibt, wird derzeit vorwiegend durch die Kombination einer im Blauen bei etwa 460 nm emittierenden Ga(In)N-LED und eines gelb emittierenden YAG:Ce³⁺-Leuchtstoffs realisiert (US 5 998 925 und EP 862 794). Dabei werden für eine gute Farbwiedergabe oft zwei verschiedene Gelb-Leuchtstoffe verwendet wie in WO-A 01/08453 beschrieben. Problematisch dabei ist, dass die beiden Leuchtstoffe oft unterschiedliches Temperaturverhalten zeigen, auch wenn ihre Struktur ähnlich ist. Ein bekanntes Beispiel ist der im Gelben lumineszierende Ce-dotierte Y-Granat (YAG:Ce) und der im Vergleich dazu längerwellig lumineszierende (Y,Gd)-Granat. Dies führt zu Farbortschwankungen und Änderungen der Farbwiedergabe bei unterschiedlichen Betriebstemperaturen.

Aus der Veröffentlichung "On new rare-earth doped M-Si-Al-O-N materials" von van Krevel, TU Eindhoven 2000, ISBN 90-386-2711-4, Kapitel 11, sind mehrere Klassen von Leuchtstoffmaterialien bekannt, die die Struktur von Nitriden oder Oxynitriden aufweisen oder die in Abkürzung ihrer Zusammensetzung als Sialone (insbesondere α-Sialone) bezeichnet werden. Mittels Dotierung mit Eu , Tb oder Ce wird eineEmission in einem breiten optischen Spektralbereich erzielt bei Anregung mit 365 nm oder 254 nm.

K. Uheda et al beschreiben einen Eu -dotierten, oxidhaltigen LaSi3N5-Leuchtstoff, der in einer Beleuchtungseinheit eingesetzt werden kann: "Synthesis and luminescent property of Eu3+-doped LaSi3N5 phosphor", Journal of Luminescence, Amsterdam, Bd. 87-89, 2000, Seiten 967-969.

### Darstellung der Erfindung

Es ist Aufgabe der vorliegenden Erfindung, eine Beleuchtungseinheit mit mindestens einer LED als Lichtquelle gemäß dem Oberbegriff des Anspruchs 1 bereitzustellen, die sich durch hohe Konstanz bei wechselnden Betriebstemperaturen auszeichnet. Eine weitere Aufgabe ist, eine Beleuchtungseinheit bereitzustellen, die weiß emittiert und insbesondere eine hohe Farbwiedergabe und hohe Ausbeute besitzt.

Diese Aufgabe wird durch die kennzeichnenden Merkmale des Anspruchs 1 gelöst. Besonders vorteilhafte Ausgestaltungen finden sich in den abhängigen Ansprüchen.

Erfindungsgemäß wird als Leuchtstoff für die LEDs ein Leuchtstoff aus einer von mehreren nitridbasierten Leuchtstoffklassen verwendet.

Es handelt sich dabei um bestimmte Klassen von Nitriden und deren DerivatenOxynitride und Sialone. Der aus einem Kation M und einem Siliziumnitrid oder einem Derivat eines Nitrids abgeleitete Leuchtstoff emittiert bei einer Wellenlänge der Peakemission von 430 bis 670 nm, wobei das Kation teilweise ersetzt ist durch einen Dotierstoff D, nämlich Eu2+ oder Ce3+, wobei als Kation M zumindest eines der zweiwertigen Metalle Ba, Ca, Sr und/oder zumindest eines der dreiwertigen Metalle Lu, La, Gd, Y verwendet wird, wobei der Leuchtstoff aus einer der folgenden Klassen stammt:
Nitride der Struktur MSi3N5, M2Si4N7, M4Si6N11 und M9Si11N23;
Oxynitride der Struktur M16Si15O6N32;
Sialone der Struktur MSiAl2O3N2, M13Si18Al12O18N36, MSi5Al2ON9 und M3Si5AlON10.

Besonders bevorzugt sind folgende spezielle Leuchtstoffe:
1. M'M"Si4N7:D
   wobei
   M'=Sr oder Ba jeweils alleine oder in Kombination, insbesondere ist M' teilweise (bis zu 20 mol-%) ersetzt durch Ca; M' ist ein zweiwertiges Ion.
   M"= Lu alleine oder in Kombination mit Gd u/o La; M" ist ein dreiwertiges Ion.
   Ein konkretes Beispiel ist SrLuSi4N7:Eu2+.
2. M'M"Si6N11:D
   wobei M' = BaxSr3-x, bevorzugt x =1.5 ; M' ist zweiwertig;
   wobei M"= Lu alleine oder in Kombination mit Gd u/o La u/o Y; M" ist dreiwertig;
   Zu einem gewissen Teil können die Ba2+ und Sr2+ Mengen noch variieren (der Wert für x kann zwischen 1,3 und 1,7 schwanken) und teilweise (bis zu 20 mol-% der Gesamtmenge M') ersetzt werden durch Ca2+.
   Ein konkretes Beispiel ist BaLuSi6N11:Eu.
3. M"3Si6N11:D
   Wobei M"= La alleine oder in Kombination mit Gd u/o Y u/o Lu; M" ist ein dreiwertiges lon.
   Bevorzugt ist D=Ce3+.
   Ein konkretes Beispiel ist La3Si6N11:Ce.
4. M'2M"7Si11N23:D
   Wobei M'=Ba alleine oder in Kombination mit Sr (bis zu 50 mol-%)
   M"= La alleine oder in Kombination mit Gd u/o Lu;
   Ein konkretes Beispiel ist Ba2La7Si11N23:Eu
5. M"Si3N5:D
   Wobei M"= La alleine oder in Kombination mit Gd u/o Lu;
   Wobei D = Ce.
   Ein konkretes Beispiel ist LaSi3N5:Ce.
   Des weiteren handelt sich dabei um bestimmte Klassen von Oxynitriden, nämlich diejenigen des Typs M"16Si15O6N32:D. diese verwenden als dreiwertiges Kation M" zumindest eines der Metalle La, Gd, Lu oder Y. Das Kation ist teilweise ersetzt durch einen Dotierstoff D, nämlich Eu2+ oder Ce3+. Besonders bevorzugt sind folgende spezielle Leuchtstoffe:
6. M"16Si15O6N32:Ce
   wobei M"= La alleine oder in Kombination mit Gd u/o Lu;
   ein konkretes Beispiel ist La16Si15O6N32:Ce.
   Des weiteren handelt sich dabei um bestimmte Klassen von Sialonen, also diejenigen des Typs MSiAION:D. Diese verwenden als zwei- oder dreiwertiges Kation M" zumindest eines der Metalle Ba, Sr, Ca, La, Gd, Lu oder Y. Das Kation ist teilweise ersetzt durch einen Dotierstoff D, nämlich Eu2+ oder Ce3+. Besonders bevorzugt sind folgende spezielle Leuchtstoffe:
7. M'SiAl2O3N2:D
   wobei M'=Sr alleine oder in Kombination mit Ba u/o Ca2+; der Anteil des Ba kann dabei bis zu 50 mol-% betragen, der des Ca bis zu 20 mol-%.
   Ein konkretes Beispiel ist SrSiAl2O3N2:Eu.
8. M'3M"10Si18Al12O18N36:D
   wobei M'=Sr alleine oder in Kombination mit Ba u/o Ca; der Anteil des Ba kann dabei bis zu 50 mol-% betragen, der des Ca bis zu 20 mol-%;
   wobei M"= La alleine oder in Kombination mit Gd u/o Lu;
   bevorzugt ist M'=Sr2+ bzw. M"=La3+;
   ein konkretes Beispiel ist Sr3La10Si18Al12O18N36:Eu.
9. M"Si5Al2ON9:Ce3+
   Wobei M"= La alleine oder in Kombination mit Gd u/o Lu;
   Ein konkretes Beispiel ist LaAl2Si5ON9:Ce.
10. M"3Si5AlON10:Ce3+
   Wobei M"= La alleine oder in Kombination mit Gd u/o Lu;
   Bevorzugt ist M"=La3+.
   Ein konkretes Beispiel ist La3Si5AlON10:Ce.

Der Anteil des Dotierstoffs (also der Eu- bzw. Ce-Anteil), der einen Teil des Kations M ersetzt, sollte bei 0,5 bis 15 %, bevorzugt 1 bis 10 %, des M-Kations liegen, wodurch eine genaue Wahl der Emissionswellenlänge getroffen werden kann und die Lichtausbeute optimiert werden kann. Ein steigender Dotierstoff-Gehalt bewirkt im allgemeinen eine Verschiebung der Peakemission zu längeren Wellenlängen hin. Überraschend hat sich herausgestellt, dass auch eine wechselnde Konzentration des Kations M die Wellenlänge der Peakemission verschiebt. Bei niedriger Konzentration des M-Kations kann man eine gute Absorption durch den Dotierstoff dadurch erhalten, dass man seinen Anteil bei 5 bis 10 mol-% des M-Kations wählt.

Diese neuen optisch aktiven Materialien können als Pigmente mit Tageslichtfluoreszenz, insbesondere auch als Leuchtstoffe, zusammengefasst werden. Damit ist gemeint, dass das Material entweder anwendbar ist als Pigment oder als lichtkonvertierendes System für Anwendungen wie Displays, Lampen oder LEDs, oder auch für beide Zwecke geeignet ist.

Ein weiterer vielversprechender Vertreter dieser Klasse der Eu-aktivierten Sialone ist ein α-Sialon, das der Formel M_{p/2}Si_{12-p-q}Al_{p+q}O_{q}N_{16-q}:Eu²⁺ gehorcht, mit M= Ca einzeln oder in Kombination mit mindestens einem der Metalle Sr oder Mg, mit q = 0 bis 2,5 und p = 0,5 bis 3, im folgenden als GO-Sialon bezeichnet.

Diese neuen optisch aktiven Materialien sind bevorzugt dotiert mit (oder sie enthalten) M2+ = Eu2+ oder M3+ = Ce3+. Im Falle einer Ce- Dotierung kann außerdem eine geringfügige Kodotierung (bis zu 30 mol-% des Ce) mit Pr3+oder Tb3+ erfolgen. Im Falle einer Dotierung mit Eu kann eine Kodotierung (bis zum Vierfachen des Eu) mit Mn2+ erfolgen. Bei diesen Kombinationen ist ein Transfer von Energie von der Erstdotierung auf die Kodotierung möglich.

Mit Bezug auf die Anwendung als Konversionsmittel für Strahlungsquellen mit einer Primärstrahlung zwischen 300 und 570 nm sind insbesondere optisch aktive Materialien mit Eu- Dotierung bevorzugt.

Die neuen optisch aktiven Materialien sind alle sehr robust, sowie thermisch und chemisch stabil, weil ihr Grundgerüst auf Tetraedern basiert, entweder vom Typ Si-(O,N) oder Al-(O,N). Hierbei bedeutet der Begriff Si-(O,N)- bzw. Al-(O,N)-Tetraeder: zum einen eine der Gruppen SiN4, SiON3, SiO2N2 oder SiO3N und zum andern eine der Gruppen AIN4, AION3, AlO2N2 oder AlO3N. Bevorzugt sind die Materialien, deren Grundgerüst Si- und/oder Al- Tetraeder mit mindestens 2 oder mehr Nitrid (N3-) Liganden enthält. Generell wurde festgestellt, dass sich die Absorption von optisch aktiven lonen D (unabhängig davon, ob sie zwei- oder dreiwertig sind), die breitbandig absorbieren, mit steigendem N-Anteil in den Tetraedern langwellig verschiebt.

Die Absorption von zweiwertigen Aktivatoren D2+, bevorzugt Eu2+ in Alleinstellung, kann, abhängig von dem Nitrid-Anteil in den Tetraedern, im Prinzip vom UV bis hin ins Orange-Rote (bis etwa 590 nm) verschoben werden. Die Absorption von dreiwertigen Aktivatoren D3+, bevorzugt Ce3+ in Alleinstellung, kann, abhängig von dem Nitrid-Anteil in den Tetraedern, im Prinzip vom UV bis ins Blau-grüne (bis etwa 495 nm) verschoben werden. Weitere Faktoren, die die Lage des Absorptionsmaximums beeinflussen, sind die Koordination und die spezifische Gitterstelle, an der sich das Aktivatorion befindet.

Die bevorzugten Gitterplätze für D2+ sind M' = Sr2+ und Ca2+, aber auch Ba2+ ist geeignet. Bevorzugt sind Koordinationszahlen von 6 bis 9 in bezug auf diese zweiwertigen Kationen. Je niedriger die Koordinationszahl ist, desto langwelliger ist die Absorption. Die Koordinationszahl hängt vom betrachteten Volumen ab, d.h. je größer man das Volumen wählt, desto höher wird die Koordination. Beispielsweise wird in SrSiAl2O3N2 das lon Sr2+ von Liganden in Gestalt der Anionen N³⁻ und O²⁻ koordiniert. Im einzelnen handelt es sich um sechs Liganden miteinem Abstand zu Sr2+ von 2.04-2.95 Å und des weiteren noch um zwei zusätzliche Liganden mit einem Abstand von etwa 3.04 Å und schließlich auch noch um einen Liganden mit einem Abstand von 3.18 Å. Somit ist abhängig vom betrachteten Volumen die Koordinationszahl entweder 6, 8 oder 9.

In der nachfolgenden Tabelle 1 sind die bevorzugten maximalen Abstände der koordinierten lonen dargestellt, wobei jeweils der Mittelwert der Abstände aller in der Koordination berücksichtigten nächstliegenden lonen genommen ist. Dies gilt im Falle ausschließlich zweiwertiger Kationen M' oder zumindest überwiegend (mehr als 80 % Anteil) zweiwertiger Kationen M'. Beispielsweise lässt sich aus der Tabelle 1 folgendes ablesen: ein Eu2+ lon, z.B. auf einer Ba2+-Stelle in einem Gitter, sollte 7 Liganden mit durchschnittlichem Abstand von höchstens 3.015 Å haben, oder es sollte 8 Liganden mit durchschnittlichem Abstand von höchstens 3.02 Å haben. Jeweils eine dieser Bedingungen, insbesondere diejenige für die geringste Ligandenanzahl, sollte erfüllt sein um die gewünschten guten Eigenschaften des Pigments zu erreichen. Die lonen Ba2+ und Sr2+ sind so groß dass sie in der Regel immer mindestens sechs Liganden um sich scharen. Das kleinere Ca2+ kommt teilweise bereits mit fünf Liganden aus. Im Falle von Mischverbindungen der drei Kationen M' gilt die Bedingung des überwiegend vorhandenen Kations.

**Tabelle 1: gemittelte bevorzugte maximale Abstände (in Å) zwischen zweiwertigem lon und Liganden in Abhängigkeit von der Anzahl der Liganden**

| *M'lon* | *Ligandenanzahl* | | | | |
|---|---|---|---|---|---|
| | 5 | 6 | 7 | 8 | 9 |
| *Ba2+* | | 2.95 | 3.015 | 3.02 | 3.03 |
| *Sr2+* | | 2.8 | 2.9 | 3.015 | 3.02 |
| *Ca2+* | 2.62 | 2.65 | 2.7 | | |

Für optische Anwendungen, bei denen D2+ = Eu2+, und wobei das optisch aktive Material Licht mit Wellenlängen zwischen 300-570 nm teilweise oder vollständig in sichtbares Licht umwandeln soll, sind die bevorzugten lonen Sr2+ und Ca2+. Die bevorzugt einzuhaltende Bedingung hinsichtlich der Koordinationssphäre ist für Sr2+ diejenige für die Ligandenanzahl 6 oder 7. Für Ca2+ ist die bevorzugt einzuhaltende Bedingung hinsichtlich der Koordinationssphäre diejenige der Ligandenanzahl 5 oder 6.

Verbindungen, die mindestens einer der Bedingungen der Tab. 1 entsprechen, haben eine hohe Absorption mit einem Maximum zwischen 300 und 570 nm, und konvertieren effizient.

Es handelt sich dabei insbesondere um Verbindungen der Klasse 7 (M'SiAl2O3N2:D) und der α-Sialone gemäß der DE-Anmeldung Az 101 33 352.8. In Tab. 2 sind einige beispiele genannt.

**Tab. 2: Abstande A1 bis A7 (in Å) des ersten bis siebten nächstliegenden Liganden sowie daraus berechneter Mittelwert Mw5 bis Mw7 der Abstände der ersten fünf bis sieben Liganden, bezogen auf das Ca- bzw. Sr-lon, für verschiedene Verbindungen**

| Verbindung | A1 | A2 | A3 | A4 | A5 | A6 | A7 | Mw5 | Mw6 | Mw7 |
|---|---|---|---|---|---|---|---|---|---|---|
| Ca_{0.68}Si₁₀Al₂N_{15.3}O_{0.7}: | | | | | | | | | | |
| Eu2+ | 2,602 | 2,602 | 2,602 | 2,631 | 2,694 | 2,695 | 2,695 | 2,626 | 2,638 | 2,646 |
| SrSiAl2O3N2:Eu2+ | 2,504 | 2,666 | 2,731 | 2,763 | 2,874 | 2,947 | 3,042 | 2,708 | 2,748 | 2,790 |
| Ca_{1.5}Al₃Si₉N₁₆:Eu2+ | 2,60 | 2,60 | 2,60 | 2,62 | 2,69 | 2,69 | 2,69 | 2,62 | 2,63 | 2,64 |

Solche Verbindungen sind thermisch und chemisch stabil. Für Anwendungen, in denen diese optisch aktiven Materialien dispergiert werden müssen (beispielsweise im Gießharz einer LED), ist ein weiterer Vorteil dieser Materialien, dass sie stoßfest sind und beim Mahlprozess in Mühlen kaum oder überhaupt nicht beschädigt werden. Derartige Beschädigungen der Körner durch den Mahlvorgang mindern bei anderen Leuchtstoffen die Effizienz.

Durch Materialdesign können so gezielt Leuchtstoffe auf Si/Al-N-Basis geschaffen werden, die eine spezifische Emission in einem weiten Bereich zwischen blau und tiefrot zeigen.

Ein besonderer Vorteil dieser nitridbasierten Systeme ist, dass es damit möglich wird, mehrere Si/Al-N-basierten Leuchtstoffe zusammen zu verwenden, die sich physikalisch ähnlich verhalten, um beispielsweise eine weiße LED zu realisieren. Eine ähnliche Überlegung gilt auch im Hinblick auf die primäre Lichtquelle, die sehr häufig ebenfalls nitridbasiert ist, da es sich dabei in der Regel um auf InN, GaN und AlN basierte Halbleiterelemente handelt. Die erfindungsgemäßen Si/Al-N-basierten Leuchtstoffe können hier besonders gut direkt aufgetragen werden.

Besondere Vorteile dieser Leuchtstoffe in Verbindung mit einer LED-basierten Beleuchtungseinheit sind hohe Effizienz, überragende Temperaturstabilität (keine Empfindlichkeit gegen Änderungen der Betriebstemperatur) und eine überraschend hohe Löschtemperatur der Lumineszenz sowie die damit erzielbare hohe Farbwiedergabe, insbesondere bei Kombination mit mindestens einem weiteren Leuchtstoff.

Ein weiterer Vorteil dieser Leuchtstoffklasse ist, dass bereits das Ausgangsmaterial (insbesondere Si₃N₄) in feinstdisperser Form vorliegt. Damit ist ein Mahlen des Leuchtstoffs häufig nicht notwendig. Dagegen müssen konventionelle Leuchtstoffe wie YAG:Ce, die ebenfalls durch Festkörpersynthese hergestellt werden, gemahlen werden, damit sie im Gießharz dispergiert bleiben und nicht auf den Boden absinken. Dieser Mahlvorgang führt häufig zu Effizienzverlusten. Diese Leuchtstoffe müssen daher nicht mehr gemahlen werden, wodurch ein Arbeitsgang gespart wird und keine Effizienzverluste auftreten. Typische mittlere Korngrößen des Leuchtstoffpulvers liegen bei 0,5 bis 5 µm.

Neben der Erzeugung einer farbigen Lichtquelle durch Anregung mittels UV-Strahlung einer LED bietet vor allem die Erzeugung von weißem Licht mit Hilfe dieser Leuchtstoffe Vorteile. Dies geschieht bei einer UV-emittierenden LED als primäre Lichtquelle unter Verwendung mindestens dreier Leuchtstoffe, bei einer blau emittierenden LED als primärer Lichtquelle unter Verwendung von wenigstens zwei Leuchtstoffen.

Weißes Licht mit guter Farbwiedergabe wird insbesondere erzeugt durch die Kombination einer UV-LED (z.B. Primäremission bei 300 bis 470 nm) mit zwei bis drei Leuchtstoffen, von denen mindestens einer ein erfindungsgemäßer nitridhaltiger Leuchtstoff ist

Die großen Vorteile nitridhaltiger Leuchtstoffe sind ihre ausgeprägte Stabilität gegenüber heißen Säuren, Laugen und auch ihre thermische und mechanische Stabilität.

### Figuren

Im folgenden soll die Erfindung anhand mehrerer Ausführungsbeispiele näher erläutert werden. Es zeigen:
- Figur 1: ein Halbleiterbauelement, das als Lichtquelle (LED) für weißes Licht dient mit (Figur 1a) und ohne (Figur 1b) Gießharz;
- Figur 2: eine Beleuchtungseinheit mit Leuchtstoffen gemäß der vorliegenden Erfindung;
- Figur 3 bis 4: das Emissionsspektrum und Reflexionsspektrum von verschiedenen nitridhaltigen Leuchtstoffen gemäß der vorliegenden Erfindung;
- Figur 5: das Emissionsspektrum einer LED mit drei nitridhaltigen Leuchtstoffen gemäß der vorliegenden Erfindung.

### Beschreibung der Zeichnungen

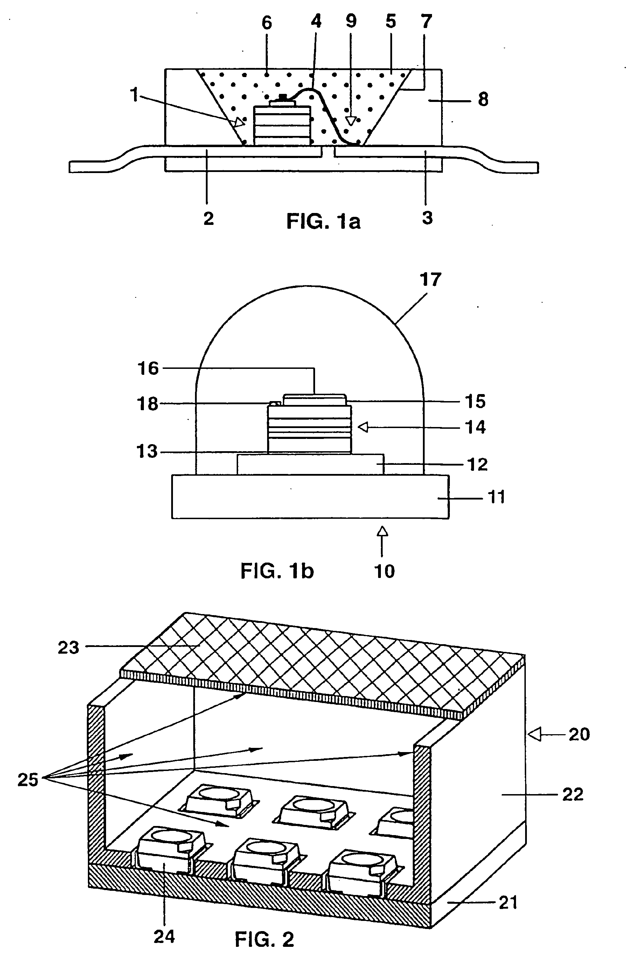

Für den Einsatz in einer weißen LED zusammen mit einem InGaN-Chip wird beispielsweise ein Aufbau ähnlich wie in US 5 998 925 beschrieben verwendet. Der Aufbau einer derartigen Lichtquelle für weißes Licht ist in Figur 1a explizit gezeigt. Die Lichtquelle ist ein Halbleiterbauelement (Chip 1) des Typs InGaN mit einer Peak-Emissionswellenlänge von 400 nm mit einem ersten und zweiten elektrischen Anschluss 2,3, das in ein lichtundurchlässiges Grundgehäuse 8 im Bereich einer Ausnehmung 9 eingebettet ist. Einer der Anschlüsse 3 ist über einen Bonddraht 4 mit dem Chip 1 verbunden. Die Ausnehmung hat eine Wand 7, die als Reflektor für die blaue Primärstrahlung des Chips 1 dient. Die Ausnehmung 9 ist mit einer Vergussmasse 5 gefüllt, die als Hauptbestandteile ein Silikongießharz (oder auch Epoxidgießharz ) (80 bis 90 Gew.-%) und Leuchtstoffpigmente 6 (weniger als 15 Gew.-%) enthält. Weitere geringe Anteile entfallen u.a. auf Methylether und Aerosil. Die Leuchtstoffpigmente sind eine Mischung aus zwei (oder auch mehr) nitridhaltigen Pigmenten, die rot und grün emittieren.

In Fig. 1b ist ein Ausführungsbeispiel eines Halbleiterbauelements 10 gezeigt, bei dem die Umwandlung in weißes Licht mittels Konversionsschichten 16 erfolgt, die direkt auf den einzelnen Chip aufgebracht sind, ähnlich wie in US 5 813 752 beschrieben. Auf einem Substrat 11 sitzt eine Kontaktschicht 12, ein Spiegel 13, eine LED 14, ein Filter 15, sowie eine durch die Primärstrahlung anregbare Leuchtstoffschicht 16 zur Konversion in sichtbare langwellige Strahlung. Diese Baueinheit ist von einer Kunststofflinse 17 umgeben. Von den beiden ohmschen Kontakten ist nur der obere Kontakt 18 dargestellt.

In Figur 2 ist ein Ausschnitt aus einer Flächenleuchte 20 als Beleuchtungseinheit gezeigt. Sie besteht aus einem gemeinsamen Träger 21, auf den ein quaderförmiges äußeres Gehäuse 22 aufgeklebt ist. Seine Oberseite ist mit einer gemeinsamen Abdeckung 23 versehen. Das quaderförmige Gehäuse besitzt Aussparungen, in denen einzelne Halbleiter-Bauelemente 24 untergebracht sind. Sie sind UVemittierende Leuchtdioden mit einerPeakemission von 360 nm. Die Umwandlung in weißes Licht erfolgt mittels Konversionsschichten 25, die auf allen der UV-Strahlung zugänglichen Flächen angebracht sind. Dazu zählen die innen liegenden Oberflächen der Seitenwände des Gehäuses, der Abdeckung und des Bodenteils. Die Konversionsschichten 25 bestehen aus drei Leuchtstoffen, die im roten, grünen und blauen Spektralbereich emittieren unter Benutzung der erfindungsgemäßen Leuchtstoffe.

Einige erfindungsgemäße Leuchtstoffe sind in Tab. 3 zusammengefasst. Es handelt sich um Sialone und Nitride verschiedener Koordinationszahl.

Tab. 4 zeigt den typischen Lumineszenzbereich (in nm) verschiedener nitridhaltiger Leuchtstoffe, die im einzelnen aufgelistet sind. Diese Leuchtstoffe decken ein weites Spektrum von Blau bis Rot ab.

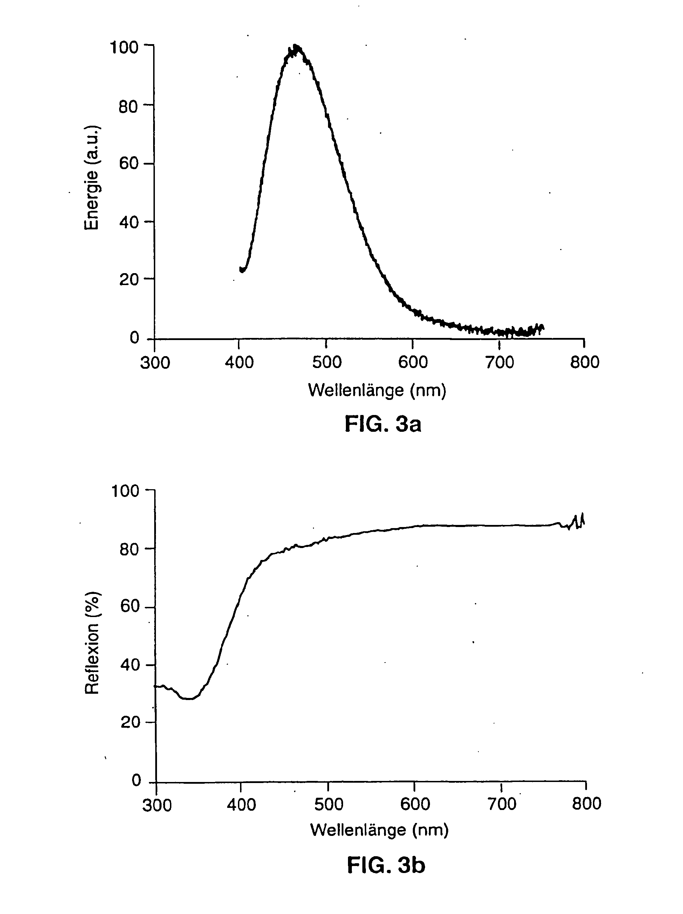

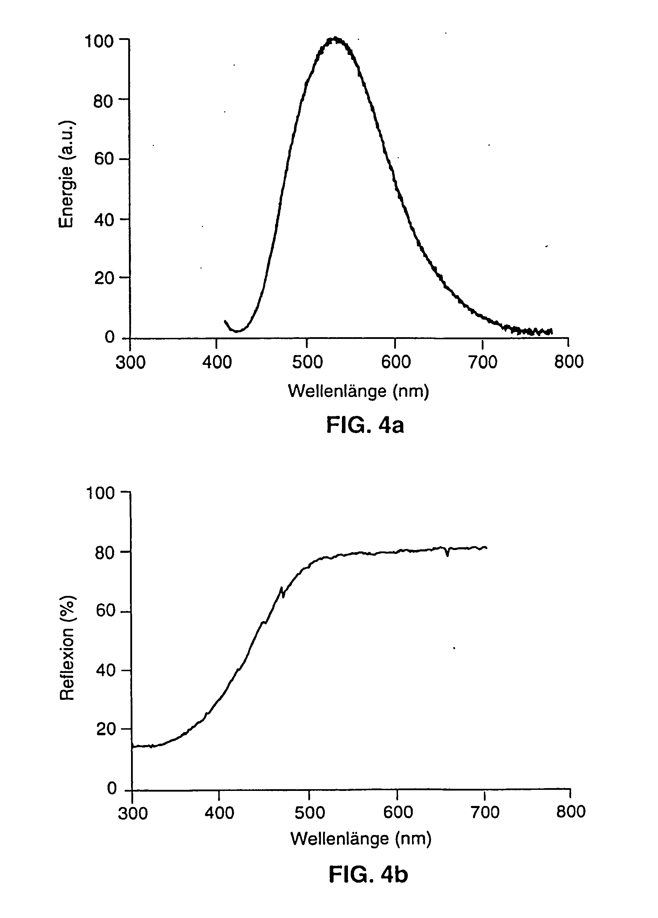

Fig. 3 und 4 zeigt die Emission und das Reflexionsverhalten verschiedener nitridhaltiger Leuchtstoffe als Funktion der Wellenlänge.

Im einzelnen zeigt Figur 3a das Emissionsspektrum des Sialons SrSiAl2O3N2:Ce3+ (4 %) ( d.h. 4 mol-% Anteil des Ce am Kation Sr) (Versuchsnummer TF23A/01) bei Anregung durch 390 nm. Das Maximum liegt im Blauen bei 466 nm, die mittlere Wellenlänge bei 493 nm. Die Reflexion (Figur 3b) beträgt bei 400 nm etwa R400 = 60% und bei 370 nm etwa R370 = 37 %.

Die Synthese des Sialons TF23A/01 wird im folgenden beispielhaft genauer beschrieben.

Das Leuchtstoffpulver wird durch eine Hochtemperatur-Festkörperreaktion hergestellt. Dazu werden beispielsweise die hochreinen Ausgangsmaterialien SrCO3, AIN und Si₃N₄ zusammengemischt mit einem Mol-Verhältnis von 1:2:1. Die Korngröße des Si₃N₄ liegt bei d₅₀ = 1,6 µm mit d₁₀ = 0,4 und d₉₀ = 3,9 µm. Eine kleine Menge CeO₂ wird zum Zwecke der Dotierung hinzugefügt und ersetzt dabei die entsprechende Molmenge SrCO3.

Nachdem die einzelnen Komponenten gut vermischt worden sind, wird das Pulver bei ca. 1400 °C für etwa 15h in einer reduzierenden Atmosphäre (N₂/H₂) erhitzt und reagiert so zu der oben angegebenen Verbindung.

Figur 4 zeigt das Emissionsspektrum (Figur 4a) des SialonsSrSiAl2O3N2:Eu2+ (4%) (Versuchsnummer TF31A/01) bei Anregung durch 400 nm. Das Maximum liegt im Grünen bei 534 nm, die mittlere Wellenlänge bei 553 nm. Die Quanteneffizienz QE ist 43%. Die Reflexion (Figur 4b) beträgt bei 400 nm etwa R400 = 31% und bei 370 nm etwa R370 = 22 %.

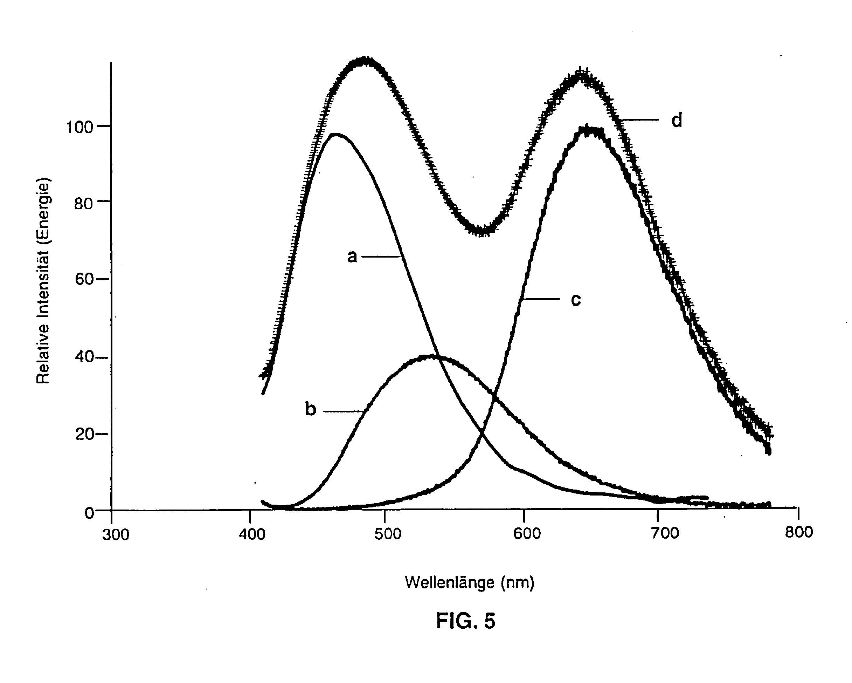

Figur 5 zeigt das Emissionsspektrum einer weißen LED auf Basis einer Primäranregung mittels InGaN-Chip mit einer Peakemission von 360 nm entsprechend dem Ausführungsbeispiel der Fig. 1a unter Verwendung der blau und grün emittierenden Sialone aus Fig. 3 und 4 sowie dem an sich bekannten rot emittierendenα Sialon Sr₂Si₅N₈:Eu, siehe WO 01/39574. Bei geeigneter Mischung ergibt sich ein Farbort von x = 0,331, y = 0,330 in unmittelbarer Nähe des Weißpunkts.

Dies zeigt die besondere Eignung der nitridhaltigen Leuchtstoffe für den Einsatz in Lumineszenzkonversions-LEDs und dabei insbesondere in Leuchtstoff-Mischungen zusammen mit anderen temperaturstabilen Leuchtstoffen.

**Tab. 3**

| Verbindung | | QE | R360 | R400 | | Max. Em. | x | y |
|---|---|---|---|---|---|---|---|---|
| SrSiAl2O3N2:Ce3+ | | 29 | 30 | 60 | | 466 | 0,182 | 0,232 |
| SrSiAl2O3N2:Eu2+ | | 51 | 25 | 42 | | 497 | 0,304 | 0,432 |
| La3Si6N11:Ce3+ | | 30 | 13 | 39 | | 451 | 0,157 | 0,145 |
| | | | | | | | | |
| | | | | | | | | |
| | | | | | | | | |
| | | | | | | | | |

**Tab. 4**

| Leuchtstoff | Dot (mol-% des Kations) | Lumineszenzbereich | | |
|---|---|---|---|---|
| SrSiAl₂O₃N₂: Eu²⁺ | 2 bis 10 | 495 bis 515 nm | | |
| CaSiAl₂O₃N₂: Eu²⁺ | 2 bis 6 | 550 bis 570 nm | | |
| SrSiAl2O3N2: Ce3+ | 2 bis 6 | 455 bis 480 nm | | |
| SrSiAl₂O₃N₂: Eu²⁺ | 1 bis 5 | 490 bis 510 nm | | |
| CaSi6AlON9:Eu²⁺ | 3 bis 6 | 570 bis 595 nm | | |
| La₃Si₆N₁₁:Ce3+ | 2 bis 5 | 435 bis 452 nm | | |
| Sr₂Si₄AlON₇:Eu²⁺ | 2 bis 4 | 625 bis 640 nm | | |

## Patentansprüche

1. Beleuchtungseinheit mit mindestens einer LED als Lichtquelle, wobei die LED primäre Strahlung im Bereich 300 bis 570 nm emittiert, wobei diese Strahlung teilweise oder vollständig in längerwellige Strahlung konvertiert wird durch Leuchtstoffe, die der primären Strahlung der LED ausgesetzt sind, und deren Strukturauf Nitriden oder deren Derivaten beruht, **dadurch gekennzeichnet, dass** die Konversion unter Zuhilfenahme zumindest eines Leuchtstoffs erfolgt, der aus einem Kation M und einem Siliziumnitrid oder einem Derivat eines Nitrids abgeleitet ist, der mit einer Wellenlänge der Peakemission bei 430 bis 670 nm emittiert, wobei das Kation teilweise ersetzt ist durch einen Dotierstoff D, nämlich Eu2+ oder Ce3+, wobei als Kation M zumindest eines der zweiwertigen Metalle Ba, Ca, Sr und/oder eines der dreiwertigen Metalle Lu, La, Gd, Y verwendet wird, wobei der Leuchtstoff aus einer der folgenden Klassen stammt:
Nitride der Struktur MSi3N5, M2Si4N7, M4Si6N11 und M9Si11N23,
Oxynitride der Struktur M16Si15O6N32
Sialone der Struktur MSiAl2O3N2, M13Si18Al12O18N36, MSi5Al2ON9 und M3Si5AlON10.

2. Beleuchtungseinheit nach Anspruch 1, **dadurch gekennzeichnet, dass** der Anteil des Dotierstoffs bei 0,5 bis 15 mol-% des Kations liegt.

3. Beleuchtungseinheit nach Anspruch 1, **dadurch gekennzeichnet, dass** im Falle einer Dotierung mit Ce³⁺ ein zusätzlicher Dotierstoff, nämlich Pr3+ u/o Tb3+, verwendet wird, dessen Anteil höchstens 30 mol-% des Anteils von Ce3+ ausmacht.

4. Beleuchtungseinheit nach Anspruch 1, **dadurch gekennzeichnet, dass** im Falle einer Dotierung mit Eu2+ ein zusätzlicher Dotierstoff, nämlich Mn2+, verwendet wird, dessen Anteil höchstens das Vierfache des Anteils von Eu2+ ausmacht.

5. Beleuchtungseinheit nach Anspruch 1, **dadurch gekennzeichnet, dass** jedes Eu2+-Ion im Leuchtstoff mindestens von zwei oder mehr Nitrid-Liganden koordiniert wird.

6. Beleuchtungseinheit nach Anspruch 1, **dadurch gekennzeichnet, dass** mehrere nitridhaltige Leuchtstoffe zusammen, und insbesondere ausschließlich, verwendet werden, um insbesondere eine weiß emittierende Beleuchtungseinheit zu realisieren.

7. Beleuchtungseinheit nach Anspruch 1, **dadurch gekennzeichnet, dass** die erfindungsgemäßen Leuchtstoffe in Silikonharz dispergiert sind oder direkt auf die LED aufgebracht sind.

8. Beleuchtungseinheit nach Anspruch 1, **dadurch gekennzeichnet, dass** die LED ein nitridbasiertes Halbleiterbauelement ist.

9. Beleuchtungseinheit nach Anspruch 6, **dadurch gekennzeichnet, dass** zur Erzeugung von weißem Licht die primär emittierteStrahlung im Wellenlängenbereich 360 bis 420 nm liegt, wobei die primär emittierte Strahlung zumindest drei Leuchtstoffen mit Emissionsmaximum im Blauen (430 bis 470 nm), Grünen (495 bis 540 nm) und Roten (insbesondere 540 bis 620 nm) zur Konversion ausgesetzt ist.

10. Beleuchtungseinheit nach Anspruch 6, **dadurch gekennzeichnet, dass** zur Erzeugung von weißem Licht die primär emittierte Strahlung im Wellenlängenbereich 420 bis 480 nm liegt, wobei die primär emittierte Strahlung zumindest zwei Leuchtstoffen mit Emissionsmaximum im Grünen (495 bis 540 nm) und Roten (insbesondere 540 bis 620 nm) zur Konversion ausgesetzt ist.

11. Beleuchtungseinheit nach Anspruch 1, **dadurch gekennzeichnet, dass** zur Erzeugung von farbigem Licht die primär emittierteStrahlung im UV-Wellenlängenbereich von 300 bis 570 nm liegt, wobei die primär emittierte Strahlung einem einzigen Leuchtstoff entsprechend einem der vorherigen Ansprüche ausgesetzt wird.

12. Beleuchtungseinheit nach Anspruch 1, **dadurch gekennzeichnet, dass** der nitridhaltige Leuchtstoff M'M"Si4N7:D ist, wobei M'=Sr oder Ba jeweils alleine oder in Kombination, (insbesondere ist M' bis zu 20 mol-% ersetzt durch Ca);
M"= Lu alleine oder in Kombination mit Gd u/o La.

13. Beleuchtungseinheit nach Anspruch 1, **dadurch gekennzeichnet, dass** der nitridhaltige Leuchtstoff M'M"Si6N11:D ist, wobei
M' = BaxSr3-x, mit 1,3 ≤ x ≤ 1,7; insbesondere mit geringem Ca-Zusatz;
M"= Lu alleine oder in Kombination mit Gd u/o La u/o Y.

14. Beleuchtungseinheit nach Anspruch 1, **dadurch gekennzeichnet, dass** der nitridhaltige Leuchtstoff M'2M"7Si11 N23:D ist, wobei M'=Ba alleine oder in Kombination mit Sr (bis zu 50 mol-%) M"= La alleine oder in Kombination mit Gd u/o Lu.

15. Beleuchtungseinheit nach Anspruch 1, **dadurch gekennzeichnet, dass** der nitridhaltige Leuchtstoff M"Si3N5:D ist, wobei M"= La alleine oder in Kombination mit Gd u/o Lu, und wobei D = Ce.

16. Beleuchtungseinheit nach Anspruch 1, **dadurch gekennzeichnet, dass** der nitridhaltige Leuchtstoff M"16Si15O6N32:Ce ist, wobei M"= La alleine oder in Kombination mit Gd u/o Lu.

17. Beleuchtungseinheit nach Anspruch 1, **dadurch gekennzeichnet, dass** der nitridhaltige Leuchtstoff M'SiA1203N2:D ist, wobei wobei M'=Sr alleine oder in Kombination mit Ba u/o Ca; insbesondere kann der Anteil des Ba dabei bis zu 50 mol-% betragen, der des Ca bis zu 20 mol-%.

18. Beleuchtungseinheit nach Anspruch 1, **dadurch gekennzeichnet, dass** der nitridhaltige Leuchtstoff M'3M"10Si18Al12O18N36:D ist, wobei wobei M'=Sr alleine oder in Kombination mit Ba u/o Ca; insbesondere kann der Anteil des Ba dabei bis zu 50 mol-% betragen, der des Ca bis zu 20 mol-%; wobei M"= La alleine oder in Kombination mit Gd u/o Lu.

19. Beleuchtungseinheit nach Anspruch 1, **dadurch gekennzeichnet, dass** der nitridhaltige Leuchtstoff M"SiSAl2ON9:Ce3+ ist, wobei wobei M"= La alleine oder in Kombination mit Gd u/o Lu.

20. Beleuchtungseinheit nach Anspruch 1, **dadurch gekennzeichnet, dass** der nitridhaltige Leuchtstoff M"3Si5AlON10:Ce3+ ist, wobei wobei M"= La alleine oder in Kombination mit Gd u/o Lu.

21. Beleuchtungseinheit nach Anspruch 1, **dadurch gekennzeichnet, dass** die Beleuchtungseinheit eine Lumineszenzkonversions-LED ist, bei der die Leuchtstoffe direkt oder mittelbar in Kontakt mit dem Chip stehen.

22. Beleuchtungseinheit nach Anspruch 1, **dadurch gekennzeichnet, dass** der nitridhaltige Leuchtstoff allein oder überwiegend zweiwertige Kationen des Typs M' enthält, mit Aktivator D2+ dotiert ist und wobei die Abstände zwischen dem Kation und den nächstliegenden Liganden zumindest einer der Bedingungen aus Tab. 1 gehorcht.

23. Beleuchtungseinheit nach Anspruch 1, **dadurch gekennzeichnet, dass** die Beleuchtungseinheit ein Feld (Array) von LEDs ist.

24. Beleuchtungseinheit nach Anspruch 12, **dadurch gekennzeichnet, dass** zumindest einer der Leuchtstoffe auf einer vor dem LED-Feld angebrachten optischen Vorrichtung angebracht ist.

25. Pigment mit Tageslichtfluoreszenz, insbesondere Leuchtstoff, dessen Struktur auf Nitriden oder deren Derivaten beruht, **dadurch gekennzeichnet, dass** die Zusammensetzung aus einem Kation M und einem Siliziumnitrid oder einem Derivat eines Nitrids abgeleitet ist, wobei das Kation teilweise ersetzt ist durch einen Dotierstoff D, nämlich Eu2+ oder Ce3+, wobei als Kation M zumindest eines der zweiwertigen Metalle Ba, Ca, Sr und/oder eines der dreiwertigen Metalle Lu, La, Gd, Y verwendet wird, wobei der Leuchtstoff aus einer der folgenden Klassen stammt:
Nitride der Struktur MSi3N5, M2Si4N7, M4Si6N11 und M9Si11N23.
Oxynitride der Struktur M16Si15O6N32
Sialone der Struktur MSiAl2O3N2, M13Si18Al12O18N36, MSi5Al2ON9 und M3Si5AlON10.

26. Pigment nach Anspruch 25, mit den Eigenschaften entsprechend einem der Ansprüche 2 bis 5.

27. Pigment nach Anspruch 25, mit den Eigenschaften entsprechend einem der Ansprüche 12 bis 20.

## Claims

1. An illumination unit having at least one LED as light source, the LED emitting primary radiation in the range from 300 to 570 nm, this radiation being partially or completely converted into the longer-wave radiation by phosphors which are exposed to the primary radiation of the LED and the structure of which is based on nitrides or derivatives thereof, **characterized in that** the conversion takes place with the aid of at least one phosphor which is derived from a cation M and a silicon nitride or a derivative of a nitride which emits with a peak emission wavelength at 430 to 670 nm, the cation being partially replaced by a dopant D, namely Eu²⁺ or Ce³⁺, at least one of the divalent metals Ba, Ca, Sr and/or at least one of the trivalent metals Lu, La, Gd, Y being used as cation M, the phosphor originating from one of the following classes:
nitrides of the structure MSi₃N₅, M₂Si₄N₇, M₄Si₆N₁₁ and MgSi₁₁N₂₃,
oxynitrides of the structure M₁₆Si₁₅O₆N₃₂
sialons of the structure MsiAl₂O₃N₂, M₁₃Si₁₈Al₁₂O₁₈N₃₆, MSi₅Al₂ON₉ and M₃Si₅AlON₁₀.

2. The illumination unit as claimed in claim 1, **characterized in that** the proportion of the dopant is 0.5 to 15 mol% of the cation.

3. The illumination unit as claimed in claim 1, **characterized in that**, in the case of doping with Ce³⁺, an additional dopant, namely Pr³⁺ and/or Tb³⁺, is used, the content of which forms at most 30 mol% of the Ce³⁺ content.

4. The illumination unit as claimed in claim 1, **characterized in that**, in the case of doping with Eu²⁺, an additional dopant, namely Mn²⁺, is used, the proportion of which additional dopant amounts to at most four times the proportion of Eu²⁺.

5. The illumination unit as claimed in claim 1, **characterized in that** each Eu²⁺ ion in the phosphor is coordinated by at least two or more nitride ligands.

6. The illumination unit as claimed in claim 1, **characterized in that** a plurality of nitride-containing phosphors are used together, and in particular exclusively, in order to produce in particular a white-emitting illumination unit.

7. The illumination unit as claimed in claim 1, **characterized in that** the phosphors according to the invention are dispersed in silicone resin or are applied directly to the LED.

8. The illumination unit as claimed in claim 1, **characterized in that** the LED is a nitride-based semiconductor component.

9. The illumination unit as claimed in claim 6, **characterized in that**, to generate white light, the primary radiation emitted is in the wavelength region from 360 to 420 nm, the primary radiation emitted being exposed to at least three phosphors with an emission maximum in the blue (430 to 470 nm), green (495 to 540 nm) and red (in particular 540 to 620 nm) for conversion.

10. The illumination unit as claimed in claim 6, **characterized in that**, to generate white light, the primary radiation emitted is in the wavelength region from 420 to 480 nm, the primary radiation emitted being exposed to at least two phosphors with an emission maximum in the green (495 to 540 nm) and red (in particular 540 to 620 nm) for conversion.

11. The illumination unit as claimed in claim 1, **characterized in that**, to generate colored light, the primary radiation emitted lies in the UV wavelength region from 300 to 570 nm, the primary radiation emitted being exposed to a single phosphor as described in one of the preceding claims.

12. The illumination unit as claimed in claim 1, **characterized in that** the nitride-containing phosphor is M'M"Si₄N₇:D, where M' = Sr or Ba, in each case alone or in combination, (in particular M' is replaced by up to 20 mol% of Ca);
M" = Lu alone or in combination with Gd and/or La.

13. The illumination unit as claimed in claim 1, **characterized in that** the nitride-containing phosphor is M'M"Si₆N₁₁:D, where M' = BaₓSr₃₋ₓ, with 1.3 ≤ x ≤ 1.7; in particular with a small amount of added Ca;
M" = Lu alone or in combination with Gd and/or La and/or Y.

14. The illumination unit as claimed in claim 1, **characterized in that** the nitride-containing phosphor is M'₂M"₇Si₁₁N₂₃:D, where M' = Ba alone or in combination with Sr (up to 50 mol%) and M" = La alone or in combination with Gd and/or Lu.

15. The illumination unit as claimed in claim 1, **characterized in that** the nitride-containing phosphor is M"Sᵢ₃N₅:D, where M" = La alone or in combination with Gd and/or Lu, and where D =Ce.

16. The illumination unit as claimed in claim 1, **characterized in that** the nitride-containing phosphor is M"₁₆Si₁₅O₆N₃₂:Ce, where M" = La alone or in combination with Gd and/or Lu.

17. The illumination unit as claimed in claim 1, **characterized in that** the nitride-containing phosphor is M'SiAl₂O₃N₂:D, where M' = Sr alone or in combination with Ba and/or Ca; in particular, the proportion of Ba may be up to 50 mol%, and the proportion of Ca may be up to 20 mol%.

18. The illumination unit as claimed in claim 1, **characterized in that** the nitride-containing phosphor is M'₃M"₁₀Si₁₈Al₁₂O₁₈N₃₆:D, where M' = Sr alone or in combination with Ba and/or Ca; in particular, the proportion of Ba may be up to 50 mol%, and the proportion of Ca may be up to 20 mol%; where M" = La alone or in combination with Gd and/or Lu.

19. The illumination unit as claimed in claim 1, **characterized in that** the nitride-containing phosphor is M" Si₅Al₂ON₉:Ce₃₊, where M" = La alone or in combination with Gd and/or Lu.

20. The illumination unit as claimed in claim 1, **characterized in that** the nitride-containing phosphor is M"₃Si₅AlON₁₀:Ce³⁺, where M" = La alone or in combination with Gd and/or Lu.

21. The illumination unit as claimed in claim 1, **characterized in that** the illumination unit is a luminescence conversion LED, in which the phosphors are in direct or indirect contact with the chip.

22. The illumination unit as claimed in claim 1, **characterized in that** the nitride-containing phosphor contains only or predominantly divalent cations of type M', is doped with activator D²⁺, the distances between the cation and the closest ligands satisfying at least one of the conditions given in Table 1.

23. The illumination unit as claimed in claim 1, **characterized in that** the illumination unit is an array of LEDs.

24. The illumination unit as claimed in claim 12, **characterized in that** at least one of the phosphors is applied to an optical device arranged in front of the LED array.

25. A pigment with daylight fluorescence, in particular a phosphor, the structure of which is based on nitrides or derivatives thereof, **characterized in that** the composition is derived from a cation M and a silicon nitride or a derivative of a nitride, the cation being partially replaced by a dopant D, namely Eu²⁺ or Ce³⁺, the cation M used being at least one of the divalent metals Ba, Ca, Sr and/or at least one of the trivalent metals Lu, La, Gd, Y, the phosphor originating from one of the following classes:
nitrides of the structure MSi₃N₅, M₂Si₄N₇, M₄Si₆N₁₁ and MgSi₁₁N₂₃,
oxynitrides of the structure M₁₆Si₁₅O₆N₃₂
sialons of the structure MsiAl₂O₃N₂, M₁₃Si₁₈Al₁₂O₁₈N₃₆, MSi₅Al₂ON₉ and M₃Si₅AlON₁₀.

26. The pigment as claimed in claim 25, having the properties described in one of claims 2 to 5.

27. The pigment as claimed in claim 25, having the properties as described in one of claims 12 to 20.

## Revendications

1. Unité d'éclairage comprenant au moins une LED à titre de source de lumière, la LED émettant un rayonnement primaire dans la plage de 300 à 570 nm, ce rayonnement étant converti en partie ou en tout en un rayonnement de plus grande longueur d'onde via des substances luminescentes qui sont exposées aux rayonnements primaires de la LED et dont la structure se base sur des nitrures ou leurs dérivés, **caractérisée en ce que** la conversion a lieu à l'aide d'au moins une substance luminescente qui dérive d'un cation M et d'un nitrure de silicium ou d'un dérivé d'un nitrure, dont la longueur d'onde maximale d'émission se situe dans la plage de 430 à 670 nm, le cation étant remplacé en partie par un dopant D, plus précisément Eu2+ ou Ce3+, un des métaux bivalents Ba, Ca, Sr et/ou un des métaux trivalents Lu, La, Gd, Y étant utilisé comme cation M, la substance luminescente étant issue d'une des classes suivantes :
des nitrures de structure MSi3N5, M2Si4N7, M4Si6N11 et M9Si11N23,
des oxynitrures de structure M16Si15O6N32,
des sialons de structure MSiAl2O3N2, M13Si18Al12O18N36, MSi5AI2ON9 et M3Si5AION10.

2. Unité d'éclairage selon la revendication 1, **caractérisée en ce que** la fraction du dopant représente de 0,5 à 15 mol % du cation.

3. Unité d'éclairage selon la revendication 1, **caractérisée en ce que**, dans le cas d'un dopant comprenant Ce3+, on utilise un dopant supplémentaire, à savoir Pr3+ et/ou Tb3+, dont la fraction représente au maximum 30 mol % de la fraction de Ce3+.

4. Unité d'éclairage selon la revendication 1, **caractérisée en ce que**, dans le cas d'un dopant comprenant Eu2+, on utilise un dopant supplémentaire, à savoir Mn2+, dont la fraction représente au maximum le quadruple de Eu2+.

5. Unité d'éclairage selon la revendication 1, **caractérisée en ce que** chaque ion Eu2+ dans la substance luminescente est coordonné avec deux ligands de nitrure ou plus.

6. Unité d'éclairage selon la revendication 1, **caractérisée en ce qu'**on utilise de manière conjointe plusieurs substances luminescentes contenant des nitrures et en particulier de manière exclusive, pour réaliser en particulier une unité d'éclairage émettant dans le blanc.

7. Unité d'éclairage selon la revendication 1, **caractérisée en ce que** les substances luminescentes selon l'invention sont dispersées dans une résine de silicone ou bien sont appliquées directement sur la LED.

8. Unité d'éclairage selon la revendication 1, **caractérisée en ce que** la LED représente un composant de semi-conducteur à base de nitrure.

9. Unité d'éclairage selon la revendication 6, **caractérisée en ce que**, pour obtenir une lumière blanche, le rayonnement d'émission primaire se situe dans la plage de longueurs d'ondes de 360 à 420 nm, le rayonnement d'émission primaire étant exposé à au moins trois substances luminescentes dont la longueur d'onde maximale d'émission se situe dans le bleu (de 430 à 470 nm), dans le vert (de 495 à 540 nm) et dans le rouge (en particulier de 540 à 620 nm) pour la conversion.

10. Unité d'éclairage selon la revendication 6, **caractérisée en ce que**, pour obtenir une lumière blanche, le rayonnement d'émission primaire se situe dans la plage de longueurs d'ondes de 420 à 480 nm, le rayonnement d'émission primaire étant exposé à au moins deux substances luminescentes dont la longueur d'onde maximale d'émission se situe dans le vert (de 495 à 540 nm) et dans le rouge (en particulier de 540 à 620 nm) pour la conversion.

11. Unité d'éclairage selon la revendication 1, **caractérisée en ce que**, pour obtenir une lumière colorée, le rayonnement d'émission primaire se situe dans la plage de longueurs d'ondes UV de 300 à 570 nm, le rayonnement d'émission primaire étant exposé à une seule substance luminescente correspondant à l'une quelconque des revendications précédentes.

12. Unité d'éclairage selon la revendication 1, **caractérisée en ce que**, la substance luminescente contenant un nitrure représente M'M"Si4N7:D, où M'=Sr ou Ba, à chaque fois seul ou en combinaison (en particulier M' est remplacé par Ca jusqu'à concurrence de 20 mol %) ;
M"= Lu seul ou en combinaison avec Gd et/ou La.

13. Unité d'éclairage selon la revendication 1, **caractérisée en ce que**, la substance luminescente contenant un nitrure représente M'M"Si6N11:D, où M' = BaxSr3-x, avec 1,3 ≤ x ≤ 1,7 ; en particulier avec une addition minime de Ca ; M"= Lu seul ou en combinaison avec Gd et/ou La et/ou Y.

14. Unité d'éclairage selon la revendication 1, **caractérisée en ce que**, la substance luminescente contenant un nitrure représente M'2M"7Si11N23:D, où M'=Ba seul ou en combinaison avec Sr (jusqu'à concurrence de 50 mol %) ; M"= La seul ou en combinaison avec Gd et/ou Lu.

15. Unité d'éclairage selon la revendication 1, **caractérisée en ce que**, la substance luminescente contenant un nitrure représente M"Si3N5:D, où M"= La seul ou en combinaison avec Gd et/ou Lu, et où D = Ce.

16. Unité d'éclairage selon la revendication 1, **caractérisée en ce que**, la substance luminescente contenant un nitrure représente M"16Si15O6N32:Ce, où M"= La seul ou en combinaison avec Gd et/ou Lu.

17. Unité d'éclairage selon la revendication 1, **caractérisée en ce que**, la substance luminescente contenant un nitrure représente M'SiAI2O3N2:D, où M'=Sr seul ou en combinaison avec Ba et/ou Ca ; en particulier, la fraction de Ba peut s'élever en l'occurrence jusqu'à 50 mol %, celle de Ca jusqu'à 20 mol %.

18. Unité d'éclairage selon la revendication 1, **caractérisée en ce que**, la substance luminescente contenant un nitrure représente M'3M"10Si18Al12O18N36:D, où M'=Sr seul ou en combinaison avec Ba et/ou Ca ; en particulier, la fraction de Ba peut s'élever en l'occurrence jusqu'à 50 mol %, celle de Ca jusqu'à 20 mol % ; où M"= La seul ou en combinaison avec Gd et/ou Lu.

19. Unité d'éclairage selon la revendication 1, **caractérisée en ce que**, la substance luminescente contenant un nitrure représente M"Si5Al2ON9:Ce3+,où M"= La seul ou en combinaison avec Gd et/ou Lu.

20. Unité d'éclairage selon la revendication 1, **caractérisée en ce que**, la substance luminescente contenant un nitrure représente M"3Si5AION10:Ce3+, où M"= La seul ou en combinaison avec Gd et/ou Lu.

21. Unité d'éclairage selon la revendication 1, **caractérisée en ce que**, la substance luminescente est une LED de conversion par luminescence, dans laquelle les substances luminescentes entrent en contact direct ou indirect avec la puce.

22. Unité d'éclairage selon la revendication 1, **caractérisée en ce que**, la substance luminescente contenant un nitrure contient, uniquement ou à titre principal, des cations bivalents du type M' et est dopée avec l'activateur D2+, et dans laquelle les distances entre le cation et les ligands les plus proches répondent au moins à une des équations du tableau 1.

23. Unité d'éclairage selon la revendication 1, **caractérisée en ce que**, la substance luminescente représente une rangée (array) de LED.

24. Unité d'éclairage selon la revendication 12, **caractérisée en ce qu'**au moins une des substances luminescentes est appliquée sur un dispositif optique disposé devant une rangée de LED.

25. Pigment fluorescent de la lumière du jour, en particulier substances fluorescentes dont la structure se base sur des nitrures ou leurs dérivés, **caractérisé en ce que** la composition dérive d'un cation M et d'un nitrure de silicium ou d'un dérivé d'un nitrure, le cation étant remplacé en partie par un dopant D, plus précisément Eu2+ ou Ce3+, un des métaux bivalents Ba, Ca, Sr et/ou un des métaux trivalents Lu, La, Gd, Y étant utilisé comme cation M, la substance luminescente étant issue d'une des classes suivantes :
des nitrures de structure MSi3N5, M2Si4N7, M4Si6N11 et M9Si11N23,
tels l'oxynitrure de structure M16Si15O6N32,
des sialons de structure MSiAl2O3N2, M13Si18Al12O18N36, MSi5AI2ON9 et M3Si5AION10.

26. Pigment selon la revendication 25, possédant les propriétés selon l'une quelconque des revendications 2 à 5.

27. Pigment selon la revendication 25, possédant les propriétés selon l'une quelconque des revendications 12 à 20.
